# EUROPÄISCHE PATENTSCHRIFT

(11) **EP 2 812 996 B1**
(45) Veröffentlichungstag und Bekanntmachung des Hinweises auf die Patenterteilung: **03.01.2018**
(21) Anmeldenummer: 13700556.7
(22) Anmeldetag: 14.01.2013
(51) Int. Cl.: H03K 17/955, B60R 25/20, H03K 17/96, E05F 15/73

(54) **VERFAHREN ZUM BETRIEB EINER KAPAZITIVEN SENSORANORDNUNG AN EINEM KRAFTFAHRZEUG UND ZUGEHÖRIGE EINRICHTUNG**
METHOD FOR THE OPERATION OF A CAPACITIVE SENSOR ARRAY ON A MOTOR VEHICLE AND ASSOCIATED DEVICE
PROCÉDÉ PERMETTANT DE FAIRE FONCTIONNER UN ENSEMBLE DE CAPTEURS CAPACITIF DISPOSÉ SUR UN VÉHICULE À MOTEUR, ET SYSTÈME ASSOCIÉ

(30) Priorität: 06.02.2012 DE 102012100960
(43) Veröffentlichungstag der Anmeldung: 17.12.2014
(73) Patentinhaber: Huf Hülsbeck & Fürst GmbH & Co. KG, 42551 Velbert (DE)
(72) Erfinder: VAN GASTEL, Peter, 42699 Solingen (DE)
(74) Vertreter: Zenz Patentanwälte Partnerschaft mbB
(86) Internationale Anmeldenummer: PCT/EP2013/050584
(87) Internationale Veröffentlichungsnummer: WO 2013/117386

(56) Entgegenhaltungen:
- WO-A1-01/08925
- DE-A1-102010 018 164

## Beschreibung

Die Erfindung betrifft eine kapazitive Sensoranordnung mit mehreren Sensorelektroden, mit deren Hilfe das Eindringen eines Objekts in einen Raum vor den Sensorelektroden erfasst wird und einer mit den Sensorelektroden gekoppelten Steuer- und Auswerteschaltung, die eine Änderung der Kapazität der Sensorelektroden gegenüber einem Referenzpotential erfasst.

Eine kapazitive Sensoranordnung mit einer Sensorelektrode, mit deren Hilfe die Annäherung eines Objekts erfasst werden soll, und mit einer mit der Sensorelektrode gekoppelten Steuer- und Auswerteschaltung, die eine Änderung der Kapazität der Sensorelektrode gegenüber Masse erfasst, indem sie die Sensorelektrode mit einer vorgegebenen Frequenz periodisch wiederholt mit einer Betriebsspannung koppelt und wenigstens einen Parameter eines vom periodischen Laden und Entladen der Sensorelektrode abhängigen Strom- oder Spannungsverlaufs zur Erfassung der Kapazitätsänderung auswertet, ist beispielsweise aus dem US-Patent 5,730,165 bzw. der entsprechenden Patentschrift DE 196 81 725 B4 bekannt. Der Parameter eines vom periodischen Laden und Entladen der Sensorelektrode abhängigen Strom- oder Spannungsverlaufs ist dabei eine über einem Kondensator messbare Spannung, die von der auf dem Kondensator angesammelten Ladung abhängt, wobei diese Ladung dadurch angesammelt wird, dass periodisch wiederholt die Sensorelektrode durch Koppeln mit der Betriebsspannung aufgeladen und anschließend durch Koppeln mit dem Kondensator über diesen entladen wird. Ein anderer derartiger kapazitiver Sensor ist aus der Patentschrift EP 1 339 025 B1 bekannt.

Die DE 10 2008 063 366 beschreibt eine gattungsgemäße Einrichtung zum berührungslosen Betätigen einer Heckklappe eines Kraftfahrzeugs mit einer ersten Sensorelektrode zur Detektion eines Objektes in einem ersten Detektionsbereich und einer zweiten Sensorelektrode zur Detektion eines Objektes in einem zweiten Detektionsbereich, so dass über die Erkennungsmittel die Betätigung der Heckklappe aktivierbar ist.

Aus der DE102010018164A1 ist eine Sensoranordnung bekannt, die zwei kapazitive Sensorelektroden verwendet, um einen Bedienwunsch eines Benutzers zur Betätigung der Heckklappe zu erfassen.

Das berührungslose Betätigen einer Heckklappe kann genutzt werden, wenn eine Person Gegenstände beispielsweise mit beiden Händen trägt und eine manuelle Betätigung der Heckklappe nicht oder nur erschwert möglich ist. Das durch die Sensorelektroden detektierte Objekt kann eine Person sein, die sich dem Kraftfahrzeug in der Absicht nähert, die Heckklappe zu betätigen. Die Betätigung der Heckklappe beschreibt dabei sowohl einen Öffnungsvorgang, beispielsweise wenn die Person einen Gegenstand beidhändig in den Kofferraum einlegen möchte oder die Betätigung der Heckklappe betrifft einen Schließvorgang der Heckklappe, wenn die Person beidhändig einen Gegenstand aus dem Kofferraum entnommen hat. Die Detektion erfasst eine Körperbewegung, die zum Beispiel das Anheben oder das Schwenken des Beins oder des Fußes der Person im von der Sensoranordnung überwachten Teil des Außenbereiches des Kraftfahrzeugs betrifft. Nachteilhafterweise kann dabei ein Signal zum Betätigen der Heckklappe auch dann ausgelöst werden, wenn es sich nicht zwingend um das Bein oder um den Fuß der Person handelt. Beispielsweise können Tiere den durch die Sensoranordnung überwachten Teil des Außenbereichs des Kraftfahrzeugs passieren oder ein Gegenstand, beispielsweise ein Ball, läuft oder rollt durch den überwachten Außenbereich. Außerdem sollen unsauber ausgeführte Betätigungsgesten bei der Detektion ausgeschlossen werden, um die Erkennungsgenauigkeit zu erhöhen.

Es ist daher wünschenswert, eine Fehlfunktion der Betätigung der Heckklappe des Kraftfahrzeugs zu vermeiden.

Aufgabe der Erfindung ist es daher, eine verlässlichere Sensorik und Auswertung bereitzustellen, welche die Fehlerfassungen von Betätigungsanforderungen reduziert.

Erfindungsgemäß wird diese Aufgabe durch eine kapazitive Sensoranordnung mit den Merkmalen des Anspruchs 1 und ein Verfahren mit den Merkmalen des Anspruchs 5 gelöst.

Die erfindungsgemäße kapazitive Sensoranordnung umfasst erste und zweite Sensorelektroden, mit deren Hilfe das Eindringen eines Objekts in einen Raum vor den Sensorelektroden erfasst werden soll. Die zwei Sensorelektrodenanordnungen sind an räumlich versetzten Positionen am Kraftfahrzeug angeordnet. Beide Sensorelektroden sind als längliche Elektrodenanordnungen ausgebildet und mit gleicher Raumorientierung angeordnet. Wenigstens einen Steuer- und Auswerteeinrichtung (5), die eine Änderung der Kapazität der Sensorelektrodenanordnungen gegenüber einem Referenzpotential erfasst ist mit den Sensorelektrodenanordnungen gekoppelt.

Eine der Sensorelektrodenanordnungen ist mit größerer Längsabmessung ausgebildet ist als die andere Sensorelektrodenanordnung, wobei sich die längere Sensorelektrodenanordnung in Längsrichtung zu beiden Seiten über die kürzere Sensorelektrodenanordnung hinaus erstreckt. Eine Sensorelektrodenanordnung ist erfindungsgemäß also zu der anderen Sensorelektrode wenigstens abschnittsweise versetzt angeordnet, z.B. in einem tiefer gelegenen oder höher gelegenen Bereich des Stossfängers. Wie die Sensorelektroden ausgebildet sind, ist für die Erfindung nicht wesentlich. Es können beispielsweise Koaxialkabel mit entsprechender Beschaltung sein, wie in der DE 10 2010 045 422 A1 beschrieben.

Die Sensorelektrodenanordnungen weisen im horizontalen Überlappungsbereich einen vertikalen Abstand auf, sind also übereinander angeordnet.

Die längere Sensorelektrodenanordnung ist im Bereich der über die kürzere Sensorelektrodenanordnung horizontal hinausragenden Abschnitte in Richtung der relativen vertikalen Position der kürzeren Sensorelektrodenanordnung verformt.

Wie oben beschrieben, sind die Elektroden abschnittsweise versetzt in vertikaler Richtung angeordnet. In dem Bereich der horizontalen Erstreckung der Elektroden, welcher von beiden Elektroden abgedeckt wird, ist also eine der Elektroden vertikal über der anderen angeordnet. Vertikal darüber bedeutet, dass bei einer Projektion auf eine vertikale Ebene, abschnittsweise ein Versatz zwischen den Projektionen der Elektroden besteht.

Die Elektroden können dabei außerdem in einer horizontalen Richtung gegeneinander versetzt angeordnet sein, welche senkrecht zu Ihrer Erstreckungsrichtung liegt. Eine Elektrode kann beispielsweise weiter zum Heck hin angeordnet sein während die andere weiter zum Fahrgastraum hin versetzt ist. Dieser Versatz kann über die Erstreckung der Elektroden unterschiedlich sein.

Die längere der Elektroden ist in den Abschnitten, welche die kürzere Elektrode überragen vertikal in Richtung der kürzeren Elektrode verformt oder geführt. Ist also beispielsweise die kürzere Elektrode mittig am Heck des Fahrzeugs angeordnet und die längere Elektrode ist vertikal darüber angeordnet, so steht die oben angeordnete, längere Elektrode seitlich über die kürzere Elektrode hinaus. In diesen Abschnitten, welche seitlich darüber hinausstehen, ist die längere Elektrode vertikal in Richtung der kürzen Elektrode geführt, hier also nach unten. Die längere Elektrode kann mit ihren äußeren Abschnitten dabei bis auf das vertikale Niveau der kürzeren Elektrode geführt sein, oder sogar darunter. Die Art der Verformung ist beliebig, es kann also eine Biegung senkrecht nach unten ausgeführt werden oder ein allmählicher, schräger oder gebogener Übergang mit horizontalen Abschnitten.

In dem genannten Fall verlaufen die Elektroden also bei rückwärtiger Ansicht in horizontaler Richtung so, dass seitlich außen Abschnitte der längeren Elektrode liegen, diese werden zur Mitte hin auf eine andere vertikale Höhe geführt und die kürzere Elektrode ist mittig dazu angeordnet, wobei sich die Elektroden jedoch nicht kreuzen.

Die Steuer- und Auswerteeinrichtung ist derart ausgebildet, dass eine Zeitfolge von Kapazitätswerten jeder der Sensorelektrodenanordnungen erfasst wird und jeweils Zeitpunkte für das Ansprechen jeder Sensorelektrodenanordnungen und das Abfallen jeder Sensoranordnung erfasst werden. Bei Prüfung auf Betätigungserfassung von der Steuer- und Auswerteeinrichtung werden die Zeitdifferenz zwischen den Zeitpunkten des Ansprechens der Sensorelektrodenanordnungen (Ansprech-Zeitdifferenz) und die Zeitdifferenz zwischen den Zeitpunkten des Abfallens der Sensorelektroden (Abfall-Zeitdifferenz) verglichen.

Die kapazitive Sensoranordnung weist ferner eine mit den Sensorelektroden gekoppelte Steuer- und Auswerteschaltung auf, die eine Änderung der Kapazität der Sensorelektroden gegenüber einem Referenzpotential erfasst.

Die Sensorelektrodenanordnungen werden in einem Heckstossfänger angeordnet, um den Bereich hinter dem Stoßfänger und unter dem Stoßfänger zu überwachen. Die Signalmuster der ersten Sensorelektrode und der weiteren Sensorelektrodenanordnung werden wiederholt abgefragt (z.B. in Reaktion auf die Detektion eines ID-Gebers von einem Keyless-Entry-System).

Diese Erfassung kann erfolgen, indem sie die Sensorelektroden mit einer vorgegebenen Frequenz periodisch auf- und entlädt und wenigstens einen Parameter eines vom periodischen Laden und Entladen der ersten Sensorelektrode abhängigen Strom- oder Spannungsverlaufs zur Erfassung der Kapazitätsänderung auswertet. Das periodische Auf- und Entladen führt sie beispielsweise aus, indem sie die Sensorelektrode mit der vorgegebenen Frequenz periodisch wiederholt mit einem vorgegebenen Potential, beispielsweise dem Betriebsspannungspotential, koppelt. Der Spannungsverlauf kann beispielsweise der Spannungsverlauf am Anschluss der ersten Sensorelektrode sein. Der Parameter kann beispielsweise eine Spannung, die über einem Ladung ansammelnden Kondensator gemessen wird, oder eine bestimmte Anzahl von Perioden des Ladens und Entladens bis zum Überschreiten einer Schaltschwelle durch eine an der ersten Sensorelektrode gemessene Spannung sein. Die Erfindung entfaltet ihre vorteilhafte Wirkung umso mehr, je kürzer die Erfassungszyklen für die Ermittlung eines Kapazitätswertes sind. Es ist zwar möglich, die Kapazitäten im Rahmen der Erfindung mit Zyklen von 30ms auszuwerten, sinnvoll ist es jedoch, die Erfassung rasche, mit Zyklen von 20ms oder besser noch kürzer (ca. 10ms) auszuführen.

Eine vorgegebene Geste eines Benutzers, z.B. ein angetäuschter Kick unter den Stossfänger, soll zu einem Öffnungs- oder Schließvorgang führen. Dafür werden die Signalfolgen der Sensorelektroden erfasst und mit Signalfolgen verglichen, welche eine gezielte Betätigung der Einrichtung anzeigen.

Die Ausbildung der Sensorelektroden mit signifikant unterschiedlicher Längserstreckung ermöglicht, dass insbesondere in den fehlerkritischen seitlichen Bereichen eine erhöhte Erkennungsgenauigkeit gewährleistet wird.

Die erfindungsgemäße Anordnung erstreckt den Erfassungsbereich einer Elektrodenanordnung in Richtung der Längserstreckung über den Erfassungsbereich der anderen Elektrode hinaus. Dadurch wird in diesem Bereich, in dem die Empfindlichkeit der kürzeren Elektrode schwindet, die Sensitivität der längeren Elektrode jedoch gleich bleibt oder sogar erhöht ist, ein räumlich inhomogenes Erfassungsprofil der Elektroden gebildet, welches auswertbar ist. Die Ausbildung der äußeren Abschnitte der längeren Elektrode in Richtung der kürzeren Elektrode verbessert die Detektion zusätzlich, wie unten beschrieben wird.

Der Erfassungsbereich der kürzeren Elektrodenanordnung ist entsprechend der geringeren körperlichen Ausdehnung stärker auf den gemeinsam von beiden Elektrodenanordnungen überspannten Längsbereich konzentriert, der üblicherweise mittig am Fahrzeug angeordnet ist. In den seitlichen Bereichen ist vornehmlich oder sogar ausschließlich die längere Sensorelektrode sensitiv. Da die Lage der Elektroden am Fahrzeug bekannt ist, können die Signale der Elektroden auf diese Weise besser differenziert werden. Wird z.B. eine Signaländerung zunächst oder nur auf der längeren Elektrode detektiert, deutet dies auf eine ungezielte Auslösung hin. Der gewünschte Erfassungsbereich liegt nämlich im Bereich der gemeinschaftlich überspannten Längserstreckung beider Elektroden. Eine gleichmäßige Verkürzung beider Elektroden ist diesbezüglich nicht hilfreich, da sie zwar den Erfassungsbereich verkleinert, eine Differenzierung in den Randbereichen aber nicht ermöglicht.

Die erfindungsgemäße Einrichtung ermöglicht verschiedene Arten der Auswertung, einerseits über die Signalstärke von beiden Elektroden und andererseits über die Signalfolge.

Erfindungsgemäß wird in einem mehrstufigen Verfahren die Signalfolge der Sensorelektroden analysiert. Dabei ist davon auszugehen, dass für eine Erfassung einer Betätigung immer eine Signalveränderung beider Elektroden erfasst wird, da sonst keine gültige Betätigung vorliegt. Die Kapazitätswerte jeder Elektrode ändern sich von einem jeweiligen Ruhewert bei Detektion einer Betätigung bis zu einem Extremwert und kehren dann auf etwa den Ruhewert zurück. Eine Betätigung wird nur erfasst, wenn die Signale beider Elektroden gegenüber dem Ruhewert eine signifikante Wertänderung erfahren, also über einen Schwellwert ansteigen (oder über einen Schwellwert absingen, je nach Auswertungsverfahren). Dieser signifikante Anstieg wird im Rahmen dieser Anmeldung als "Ansprechen" bezeichnet. Der Zeitpunkt, wenn der Messwert wieder in den Bereich des Ruhewertes sinkt, also unterhalb der Auslöseschwelle, wird als "Abfallen" bezeichnet. Das Ansprechen oder Abfallen kann allerdings im Rahmen der Erfindung in anderer Weise als durch einen Schwellwert definiert werden.

Erfindungsgemäß wird zu jeder Elektrode der Zeitpunkt erfasst, zu dem diese Elektrode anspricht, also z.B. den vorgegebenen Schwellwert kreuzt.

Es wird also erfasst:
- wann die erste Elektrode anspricht, also z.B. wann das Signal der ersten Elektrode den Schwellwert übersteigt;
- wann die zweite Elektrode anspricht, also z.B. wann das Signal der zweiten Elektrode den Schwellwert übersteigt;
- wann die erste Elektrode abfällt, also z.B. wann das Signal der ersten Elektrode den Schwellwert wieder unterschreitet;
- wann die zweite Elektrode abfällt, also z.B. wann das Signal der zweiten Elektrode den Schwellwert wieder unterschreitet;

Erfindungsgemäß wird in einem Schritt des Erfassungsverfahrens geprüft, ob die Signalfolge mit plausiblen zeitlichen Abständen erfolgt. Es wird dabei davon ausgegangen, dass nur zeitlich in etwa symmetrische Vorgänge eine korrekte Benutzergeste wiedergeben. Hierzu wird der Zeitabstand zwischen Ansprechen (Überschreiten des Erfassungsschwellwertes) der ersten und zweiten Elektrode einerseits mit dem Zeitabstand zwischen Abfallen (Unterschreiten des Erfassungsschwellwertes) der zweiten und ersten Elektroden andererseits verglichen.

Nur wenn diese Zeitabstände bis auf einen Toleranzwert gleich sind, ist eine Betätigungserkennung möglich, ansonsten wird die Auswertung abgebrochen. Der Toleranzwert ist dabei ein konstanter oder prozentualer Zeitwert. Ein prozentualer Zeitwert, bezogen auf den genannten Zeitabstand (z.B. bis zu 50% der kleineren Zeitdifferenz), berücksichtigt die Geschwindigkeit, mit der die Betätigung ausgeführt wird. Der Toleranzwert kann jedoch auch aus den Messwerten anders hergeleitet werden oder auch ein zu dem erfassten ID-Geber zugeordneter und im Fahrzeug gespeicherter Toleranzwert sein.

Ein Schritt der Erfassung prüft also die zeitliche Symmetrie der Betätigungsbewegung bei Hin- und Rückweg. Diese erfindungsgemäße Filterung der Betätigungssignale erkennt solche Bewegungen als ungeeignete Gesten, die unsymmetrisch ausgeführt werden. Wird bei einer Kick-Bewegung unter den Stoßfänger das Bein z.B. in einem Halbkreis oder schräg wieder zurückgezogen, führt dies zu unterschiedlichen Vergleichszeiten.

Hier wird es deutlich, dass die zeitliche Auflösung erfindungsgemäß relevant ist, da die Zeitwerte mit dieser Auflösung verbunden sind. Je höher die zeitliche Auflösung, desto genauer kann die Symmetrie der Bewegung geprüft werden.

In einem weiteren Auswertungsschritt wird außerdem die Abfolge des Ansprechens der Elektroden geprüft. Die Signalfolge muss konsistent sein. Dies bedeutet, dass die zuerst ansprechende Elektrode immer auch die zuletzt anfallende sein muss. Die Elektroden müssen in entgegengesetzter Reihenfolge mit ihren Signalen wieder unter die Erfassungsgrenze abfallen, wie sie angesprochen haben.

Über die räumliche Anordnung kann außerdem eine weitere Differenzierung vorgenommen werden, wie unten beschrieben wird. Der Überstand der Elektroden auf beiden Seiten kann symmetrisch bemessen sein, dies ist jedoch nicht zwingend erforderlich.

Vorzugsweise beträgt der Längenunterschied der Sensorelektrodenanordnungen 30%-100%. Ein derartiger, Längenunterschied gewährleistet einerseits, dass ein deutlicher Überstand vorhanden ist, der auch zu deutlichen Signalunterschieden führt. Andererseits ist auch ein signifikanter Anteil eines gemeinsamen Erstreckungsbereiches vorhanden, welcher in diesem Bereich eine Detektion, z.B. von Bewegungsgesten erlaubt.

Vorteilhafte und/oder bevorzugte Ausführungsformen sind in den Unteransprüchen gekennzeichnet.

Die Erfindung wird nun anhand der beiliegenden Figuren näher erläutert.
Figur 1A zeigt die Anordnung einer ersten Ausführungsform der erfindungsgemäßen Sensoranordnung an einem Kraftfahrzeug;
Figur 1B zeigt die Anordnung aus Figur 1A in einer schematischen Aufsicht;
Figur 2A zeigt einen schematischen Signalverlauf bei Detektion einer akzeptierten Betätigungsbewegung mit einer Sensoranordnung aus Figur 4a;
Figur 2B zeigt einen schematischen Signalverlauf bei Detektion einer nicht akzeptierten Betätigungsbewegung mit einer Sensoranordnung aus Figur 4a;

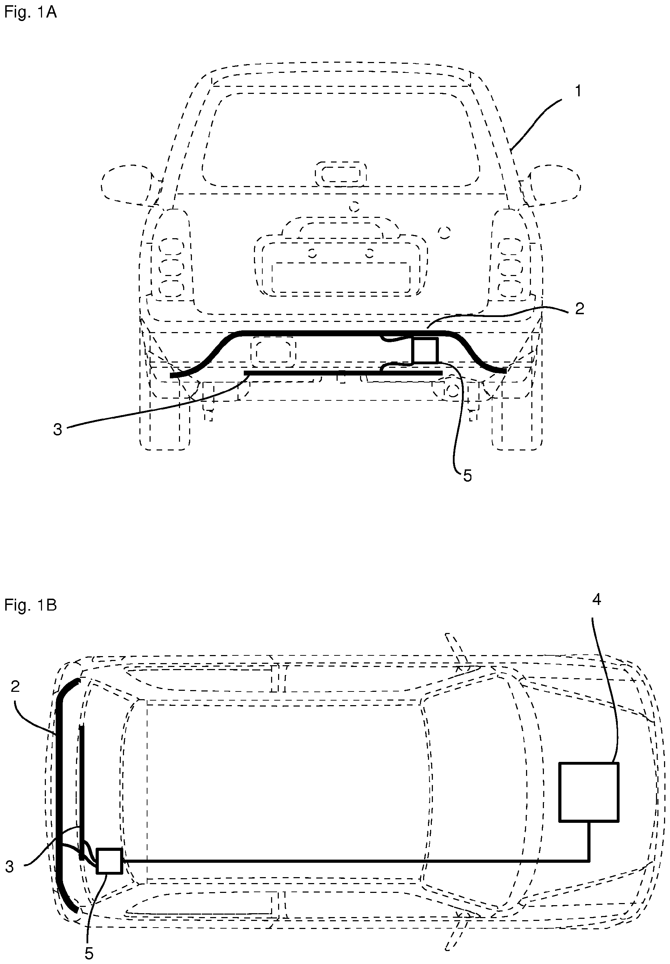

In Figur 1A ist das Heck eines Fahrzeugs 1 gezeigt. Im Bereich des Heckstossfängers ist eine Sensorelektrodenanordnung 2 angebracht. Unterhalb (also in geringerer vertikaler Höhe vom Boden) der Sensorelektrodenanordnung 2 ist eine weitere Sensorelektrode 3 angeordnet. Die Sensorelektroden 2 und 3 sind jeweils mit einer Steuer- und Auswerteeinrichtung 5 verbunden. Diese ist wiederum mit einer zentralen Fahrzeugsteuereinheit 4 gekoppelt, welche eine Öffnung der Heckklappe des Fahrzeugs kontrolliert und freigibt, wenn ein entsprechendes Signal von der Steuereinrichtung 5 generiert wird. Die Elektroden werden über die Einrichtung 5 aufgeladen und die Kapazitätsänderung der Elektroden bei Annäherung eines Körpers, z.B. eines Bedienerkörperteils kann durch Ladungsauswertung erfasst werden. Dieses Prinzip eines kapazitiven Sensors ist im Bereich der Kraftfahrzeugtechnik bekannt (siehe oben).

Die Sensorelektrodenanordnung 3 verläuft im mittleren Abschnitt parallel zu der Elektrode 2. Die Elektrodenanordnung 2 erstreckt sich jedoch horizontal länger als die Elektrodenanordnung 3 und steht seitlich über die Enden der Elektrode 3 hinaus. Die Elektroden 2 und 3 sind hier durchgehend mit im Wesentlichen gleichbleibender Empfindlichkeit ausgebildet.

Wie insbesondere in Fig. 1B erkennbar, ist die Elektrode 3 nicht nur tiefer (also vertikal nach unten gegenüber Elektrode 2) sondern auch weiter in Richtung Fahrgastraum angeordnet. Die Elektrode 3 liegt also weiter unter dem Fahrzeug als Elektrode 2. Der Erfassungsbereich der Elektrode 3 ist entsprechend auch weiter in Richtung Unterboden des Fahrzeugs versetzt.

Wie in Figur 1A zu erkennen, ist die Elektrode 2 in den Bereichen, in denen sie über die Elektrode 3 hinaus steht nach unten gebogen und geführt. Mit ihren äußeren Abschnitten erreicht die Elektrode 2 das vertikale Niveau der Erstreckung der Elektrode 3. Wie die Figur 1B außerdem zeigt, ist die Elektrode 2 auch in der horizontalen Richtung entlang der Längsachse des Fahrzeuges in den Außenbereichen geformt. Die Elektrode 2 folgt beispielsweise der Karosserieform und ist in den Seitenbereichen entlang der Rundung des Stoßfängers, um die Ecke herum geführt.

Bei einem Bedienerwunsch kann ein Bediener bspw. seinen Unterschenkel in einer Schwenkbewegung unter den Stoßfänger bewegen. Diese Bewegung und Annäherung wird sowohl durch die verlängerte Elektrodenanordnung 2 erfasst, als auch durch die Sensorelektrode 3, da die Kapazitätsänderung zeitlich wiederholt abgefragt und die Veränderung ausgewertet wird. Die Frequenz der Abfrage der Kapazitätsänderung, also die Häufigkeit der Ermittlung aktueller Kapazitätswerte liegt in diesem Beispiel bei 120Hz (für jede Kapazitätserfassung ist eine Anzahl von Ladevorgängen zu absolvieren - siehe oben).

Durch die unterschiedliche Länge der Elektroden dehnen sich außerdem deren jeweilige Erfassungsbereiche seitlich unterschiedlich weit aus.

Es ist ersichtlich, dass die Elektrode 2 in den Seitenbereichen einen verformten Erfassungsbereich aufweist. Die verschiedenen Bedienszenarien lassen sich erfindungsgemäß in unterschiedlicher Weise differenzieren.

Betätigt ein Bediener per Kick-bewegung die Heckklappe, hängt die Reaktion des Systems von mehreren Bedingungen ab. Wie oben beschrieben, wird erfindungsgemäß sowohl die korrekte Reihenfolge (Symmetrie der Aktivierung) der Elektrodensignale überwacht, als auch eine Symmetrie hinsichtlich der Zeitabläufe.

In den Randbereichen, also den Bereichen in denen sich lediglich die Elektrode 2 erstreckt, jedoch nicht die Elektrode 3, spricht auch bei korrekter Kick-Bewegung die Elektrode 3 nicht an. Wird eine Kick-Bewegung in diesem Bereich gestartet und das Bein in den mittleren Bereich des Fahrzeuges während dieser Kick-bewegung bewegt, so führt dies aufgrund der Formgebung der Elektrode zu einem erheblichen "zeitlichen Vorsprung" der Erfassung durch die Elektrode 2, so dass beim Zurückziehen des Beines in einem Bereich, der auch Erfassungsbereich der Elektrode 2 ist, ein zeitlich asymmetrisches Bild vorliegt. Die Zeitspanne von der Erfassung des Eintritts des Fußes in den Detektionsbereich der Elektrode 2 (Randbereich) bis zum Erfassen durch die Elektrode 3 einerseits und dem Verlassen des Erfassungsbereichs der Elektrode 3 (nun im mittleren Bereich des Fahrzeuges) und des Erfassungsbereichs der Elektrode 2 andererseits ist deutlich unterschiedlich und wird erfindungsgemäß als Betätigung verworfen.

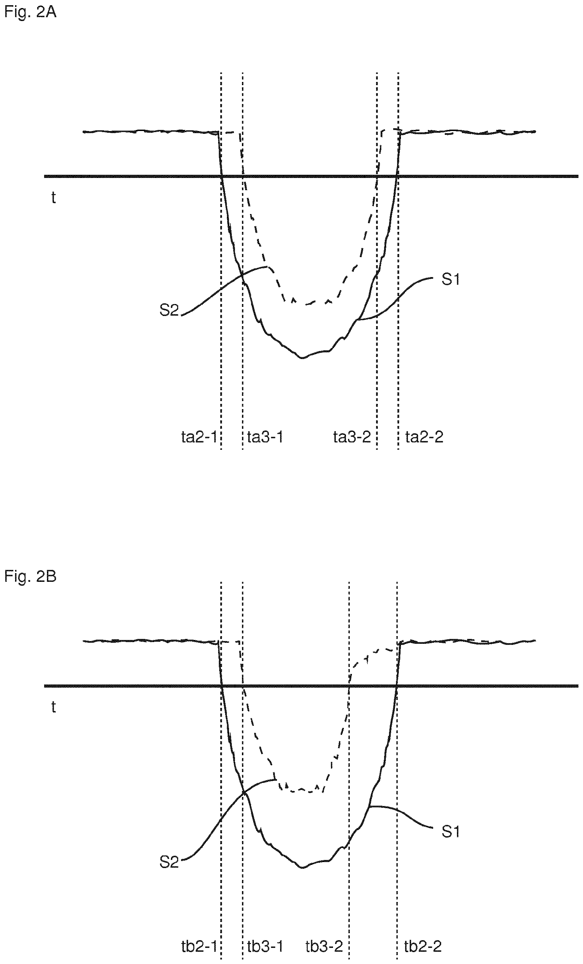

Die Erkennung von unsauber ausgeführten Betätigungsbewegungen oder seitliche Bewegungen im mittleren Bereich ist ebenfalls erfindungsgemäß möglich. Ein entsprechender Signalverlauf ist in der Figur 2A gezeigt. Dort sind die Elektrodensignale der Elektroden 2 und 3 als Signale S1 bzw. S2 dargestellt. Wird eine Betätigungsbewegung durch Schwenken des Unterschenkels in Richtung des Fahrzeuges und anschließendes zurückziehen desselben initiiert, so spricht erst die Elektrode 2 an, indem das Signal der Elektrode 2, erfasst mit dem Steuergerät 5, über einen vorgegebenen Schwellwert steigt. Der Zeitpunkt ta2-1 (Ansprechen der Elektrode 2) wird erfindungsgemäß erfasst.

Der Eintritt des Unterschenkels oder Fußes in den Erfassungsbereich der Elektrode 3 wird durch Überschreiten eines zugehörigen Schwellwertes (Ansprechen der Elektrode 3) ebenfalls in dem Steuergerät 5 erfasst, und zwar zum Zeitpunkt ta3-1.

Beim Herausziehen des Unterschenkels verlässt dieser zunächst den Erfassungsbereich der Elektrode 3, das Signal dieser Elektrode fällt zum Zeitpunkt ta3-2 unter den Schwellwert (Abfallen der Elektrode 3). Schließlich verlässt der Unterschenkel auch wieder den Bereich der Elektrode zwei, so dass auch dieser Wert wieder unter den Schnellwert fällt (Zeitpunkt ta2-2 / (Abfallen der Elektrode 2).

Die Zeitpunkte, bei denen die Schwellenwerte überschritten und unterschritten werden sind in Figur 2A markiert. Erfindungsgemäß werden die beiden Zeitdifferenzen (ta3-1)-(ta2-1) und (ta2-2)-(ta3-2) gebildet, welche zur erfolgreichen Erkennung einer zugelassenen Betätigungsbewegung maximal um 20 % voneinander abweichen dürfen.

Die Figur 2B zeigt einen Fall, in dem dieses Kriterium nicht erfüllt ist. Ein Betätiger hat nach einschwenken des Fußes diesen seitlich bewegt, so dass er aus dem zentralen Erfassungsbereich der kürzeren Elektrode heraus bewegt wurde und dort einen flacheren Signalverlauf zeigt. Die entsprechenden Signalabstände (tb3-1)-(tb2-1) und (tb2-2)-(tb3-2) weichen daher um mehr als die zugelassene prozentuale Abweichung voneinander ab. Der Signalverlauf in Figur 2B würde nicht als zulässige Betätigungsgeste erfasst.

Eine solche Signalform mit asymmetrischen Abständen ergibt sich beispielsweise, wenn ein Bediener, z.B. im Erfassungsbereich "von einem Bein auf das andere tritt" oder z.B. zum Heben oder beim Neupositionieren einer getragenen Last die Beine bewegt (abstützen einer Last durch den Oberschenkel). Insbesondere immer dann, wenn der Bediener keine Stabilität bei der Ausführung einer Bewegung hat, tritt eine erfassbare Querbewegung hinzu. Diese Bewegungen sollen nicht als Öffnungsbetätigung erkannt werden, um keine unerwünschten Öffnungsvorgänge herbeizuführen.

Schließlich wird erfindungsgemäß auch noch geprüft, ob die Elektroden in umgekehrter Reihenfolge abschalten wie sie den Eintritt eines Objektes in ihrem Erfassungsbereich gemeldet haben. Dies schließt insbesondere unerwünschte Bewegungsabläufe aus, wie zum Beispiel unter dem Fahrzeug herlaufende Tiere oder rollende Gegenstände.

Selbstverständlich können im Rahmen einer Betätigungserkennung weitere Prüfungen der Sensordaten durchgeführt werden. Die Erfindung betrifft jedoch Ausschlusskriterien, wann eine Betätigung als ungültig zu verwerfen ist.

## Patentansprüche

1. Sensoranordnung an einem Kraftfahrzeug zur Erfassung von Bewegungsgesten,
wobei zwei Sensorelektrodenanordnungen (2, 3) an räumlich versetzten Positionen am Kraftfahrzeug angeordnet sind, wobei die Sensorelektroden (2, 3) als längliche Elektrodenanordnungen ausgebildet und mit gleicher Raumorientierung angeordnet sind, und mit wenigstens einer mit den Sensorelektrodenanordnungen gekoppelten Steuer- und Auswerteeinrichtung (5), die die dazu ausgebildet ist eine Änderung der Kapazität der Sensorelektrodenanordnungen gegenüber einem Referenzpotential zu erfassen, wobei eine (2) der Sensorelektrodenanordnungen mit größerer Längsabmessung ausgebildet ist als die andere (3) Sensorelektrodenanordnung, wobei sich die längere Sensorelektrodenanordnung (2) in Längsrichtung zu beiden Seiten über die kürzere Sensorelektrodenanordnung (2) hinaus erstreckt,
wobei die Sensorelektrodenanordnungen im horizontalen Überlappungsbereich einen vertikalen Abstand aufweisen, also übereinander angeordnet sind,
wobei die längere Sensorelektrodenanordnung (2) im Bereich der über die kürzere Sensorelektrodenanordnung (3) horizontal hinausragenden Abschnitte in Richtung der vertikalen Lage der kürzeren Sensorelektrodenanordnung (3) verformt ist,
wobei die Steuer- und Auswerteeinrichtung derart ausgebildet ist, dass eine Zeitfolge von Kapazitätswerten jeder der Sensorelektrodenanordnungen (2, 3) erfasst wird und jeweils Zeitpunkte für das Ansprechen jeder Sensorelektrodenanordnungen und das Abfallen jeder Sensoranordnung erfasst werden und dass bei Prüfung auf Betätigungserfassung von der Steuer- und Auswerteeinrichtung (5) die Zeitdifferenz zwischen den Zeitpunkten des Ansprechens der Sensorelektrodenanordnungendie sogenannte Ansprech-Zeitdifferenz - und die Zeitdifferenz zwischen den Zeitpunkten des Abfallens der Sensorelektroden - die sogenannte Abfall-Zeitdifferenzverglichen werden.

2. Sensoranordnung nach Anspruch 1, wobei eine Betätigungserfassung von der Steuer- und Auswerteeinrichtung (5) ausgeschlossen wird, wenn die Zeitdifferenz zwischen den Zeitpunkten des Ansprechens der Sensorelektrodenanordnungen von der Zeitdifferenz zwischen den Zeitpunkten des Abfallens der Sensorelektroden um mehr als 50%, vorzugsweise mehr als 20% abweicht.

3. Sensoranordnung nach einem der vorangehenden Ansprüche, wobei die kürzere Sensorelektrodenanordnung zentriert zu der längeren Sensorelektrodenanordnung und vertikal unterhalb dieser angeordnet ist, wobei die längere Sensorelektrodenanordnung mit ihren äußeren Abschnitten nach unten geführt ist.

4. Sensoranordnung nach einem der vorangehenden Ansprüche, wobei die Steuer- und Auswerteeinrichtung derart ausgebildet ist, dass bei Prüfung auf Betätigungserfassung von der Steuer- und Auswerteeinrichtung (5) geprüft wird, ob die Reihenfolge der Zeitpunkte des Ansprechens der Sensorelektrodenanordnungen gleich der umgekehrte Reihenfolge des Abfallens der jeweiligen Sensorelektroden ist.

5. Verfahren zum Erfassen von Bewegungsgesten an einem Kraftfahrzeug mit einer kapazitiven Sensoranordnung (2, 3) und wenigstens einer mit der Sensoranordnung gekoppelten Steuer- und Auswerteeinrichtung (5), die eine Änderung der Kapazität der Sensoranordnung gegenüber einem Referenzpotential erfasst,
wobei zwei Sensorelektrodenanordnungen (2, 3) an räumlich versetzten Positionen am Kraftfahrzeug angeordnet werden, wobei die Sensorelektroden (2, 3) als längliche Elektrodenanordnungen ausgebildet sind und mit gleicher Raumorientierung angeordnet werden, wobei eine (2) der Sensorelektrodenanordnungen mit größerer Längsabmessung ausgebildet ist als die andere (3) Sensorelektrodenanordnung, wobei sich die längere Sensorelektrodenanordnung (2) in Längsrichtung zu beiden Seiten über die kürzere Sensorelektrodenanordnung (2) hinaus erstreckt,
wobei die Elektroden im horizontalen Überlappungsbereich einen vertikalen Abstand aufweisen, also übereinander angeordnet sind,
wobei die längere Sensorelektrodenanordnung (2) im Bereich der über die kürzere Sensorelektrodenanordnung (3) horizontal hinausragenden Abschnitte in Richtung der vertikalen Lage der kürzeren Sensorelektrodenanordnung (3) verformt ist,
mit den Schritten:
Erfassen einer Zeitfolge von Kapazitätswerten jeder der Sensorelektrodenanordnungen (2, 3);
Bestimmen der Zeitpunkte für das Ansprechen jeder Sensorelektrodenanordnungen und das Abfallen jeder Sensoranordnung;
Bilden der Ansprech-Zeitdifferenz zwischen den Zeitpunkten des Ansprechens der Sensorelektrodenanordnungen;
Bilden der die Abfall-Zeitdifferenz zwischen den Zeitpunkten des Abfallens der Sensorelektroden;
Vergleichen der Ansprech-Zeitdifferenz und der Abfall-Zeitdifferenz;
Bestimmen, dass eine ungültige Betätigung vorliegt, wenn der Vergleich eine Abweichung zwischen Ansprech-Zeitdifferenz und der Abfall-Zeitdifferenz ergibt, die größer ist als eine vorgegebene Toleranz.

6. Verfahren nach Anspruch 5, wobei außerdem geprüft wird, ob die Reihenfolge der Zeitpunkte des Ansprechens der Sensorelektrodenanordnungen gleich der umgekehrten Reihenfolge des Abfallens der jeweiligen Sensorelektroden ist.

7. Sensoranordnung nach Anspruch 5 oder 6, wobei die Toleranz 50% der kleineren Zeitdifferenz, vorzugsweise 20% der kleineren Zeitdifferenz beträgt.

## Claims

1. A sensor array on a motor vehicle, for detecting movement gestures,
wherein two sensor electrode arrays (2, 3) are arranged at spatially offset positions on the motor vehicle, wherein the sensor electrodes (2, 3) are in the form of elongate electrode arrays and are arranged with the same spatial orientation, and with at least one control and evaluation device (5), which is coupled to the sensor electrode arrays and is designed to detect a change in the capacitance of the sensor electrode arrays compared with a reference potential, wherein
one of the sensor electrode arrays (2) is longer than the other sensor electrode array (3), wherein the longer sensor electrode array (2) extends beyond the shorter sensor electrode array (2) on both sides in the longitudinal direction,
wherein the sensor electrode arrays have a vertical spacing in the horizontal overlap region, that is, are arranged one above the other,
wherein the longer sensor electrode array (2) is deformed, in the region of the sections projecting horizontally beyond the shorter sensor electrode array (3), towards the vertical position of the shorter sensor electrode array (3),
wherein the control and evaluation device is designed such that a sequence of capacitance values of each of the sensor electrode arrays (2, 3) is detected and time points at which each sensor electrode array responds and at which each sensor array stops responding are detected and that the time difference between the time points at which the sensor electrode arrays respond - what is known as the response time difference - and the time difference between the time points at which the sensor electrodes stop responding - what is known as the dropout time difference - are compared when assessing whether an operation action has been detected by the control and evaluation device (5) .

2. The sensor array according to claim 1, wherein it is concluded that an operation action has not been detected by the control and evaluation device (5) if the time difference between the time points of the response of the sensor electrode arrays deviates from the time difference between the time points of the dropout of the sensor electrodes by more than 50 %, preferably more than 20 %.

3. The sensor array according to any one of the preceding claims, wherein the shorter sensor electrode array is centred relative to the longer sensor electrode array and arranged vertically below the latter, wherein the outer sections of the longer sensor electrode array lead downwards.

4. The sensor array according to any one of the preceding claims, wherein the control and evaluation device is designed such that, when assessing whether an operation action has been detected by the control and evaluation device (5), it is checked whether the order of the time points of the response of the sensor electrode arrays is the same as the reversed order of the dropout of the respective sensor electrodes.

5. A method for detecting movement gestures on a motor vehicle, having a capacitive sensor array (2, 3) and at least one control and evaluation device (5), which is coupled to the sensor array and detects a change in the capacitance of the sensor array compared with a reference potential,
wherein two sensor electrode arrays (2, 3) are arranged at spatially offset positions on the motor vehicle, wherein the sensor electrodes (2, 3) are in the form of elongate electrode arrays and are arranged with the same spatial orientation, wherein one of the sensor electrode arrays (2) is longer than the other sensor electrode array (3), wherein the longer sensor electrode array (2) extends beyond the shorter sensor electrode array (2) on both sides in the longitudinal direction,
wherein the electrodes have a vertical spacing in the horizontal overlap region, that is, are arranged one above the other,
wherein the longer sensor electrode array (2) is deformed, in the region of the sections projecting horizontally beyond the shorter sensor electrode array (3), towards the vertical position of the shorter sensor electrode array (3),
having the steps:
detecting a sequence of capacitance values of each of the sensor electrode arrays (2, 3);
determining the time points at which each sensor electrode array responds and at which each sensor array stops responding;
calculating the response time difference between the time points at which the sensor electrode arrays respond;
calculating the dropout time difference between the time points at which the sensor electrodes stop responding;
comparing the response time difference and the dropout time difference;
determining that an invalid operation is present if the comparison produces a deviation between the response time difference and the dropout time difference which is greater than a predefined tolerance.

6. The method according to claim 5, wherein it is also checked whether the order of the time points of the response of the sensor electrode arrays is the same as the reversed order of the dropout of the respective sensor electrodes.

7. The sensor array according to claim 5 or 6, wherein the tolerance is 50 % of the smaller time difference, preferably 20 % of the smaller time difference.

## Revendications

1. Dispositif de détection au niveau d'un véhicule automobile pour l'enregistrement de gestes de mouvement,
dans lequel deux dispositifs d'électrodes de détection (2, 3) sont disposés à des positions spatialement décalées au niveau du véhicule automobile, les électrodes de détection (2, 3) étant réalisées sous forme de dispositifs de détection oblongs et avec la même orientation spatiale, et comportant au moins un dispositif de commande et d'exploitation (5) couplé à au moins un des dispositifs d'électrodes de détection et qui est conçu pour détecter une modification de capacité des dispositifs d'électrodes de détection par rapport à un potentiel de référence,
un (2) des dispositifs d'électrodes de détection étant réalisé avec une dimension longitudinale supérieure à celle de l'autre (3) dispositif d'électrode de détection, le dispositif d'électrodes de détection le plus long (2) s'étendant dans le sens longitudinal des deux côtés au-delà du dispositif d'électrode de détection (2) plus court,
les dispositifs d'électrodes de détection présentant dans la zone horizontale de chevauchement une distance verticale, donc étant superposés,
le dispositif d'électrode de détection le plus long (2) étant déformé au niveau des sections dépassant horizontalement du dispositif d'électrode de détection plus court (3) en direction de la position verticale du dispositif d'électrode de détection plus court (3), le dispositif de commande et d'exploitation étant conçu de manière à détecter une suite chronologique de valeurs de capacité de chacun des dispositifs d'électrodes de détection (2, 3) et des moments de réaction de chaque dispositif d'électrode de détection et de défection de chaque dispositif de détection étant respectivement détectés et, lors du contrôle de la détection d'actionnement du dispositif de commande et d'exploitation (5), la différence chronologique entre les moments de réaction des dispositifs de détection à électrodes - dite différence de temps de réaction - et la différence chronologique entre les moments de défection des électrodes de détection - dite différence de temps de défection - étant comparées.

2. Dispositif de détection selon la revendication 1, dans lequel une détection d'actionnement est exclue par le dispositif de commande et d'exploitation (5) lorsque la différence chronologique entre les moments de réaction des dispositifs d'électrode de détection diverge de plus de 50 %, de préférence de plus de 20 %, de la différence chronologique entre les moments de défection des électrodes de détection.

3. Dispositif de détection selon une des revendications précédentes, dans lequel le dispositif d'électrode de détection le plus court est disposé centré par rapport au dispositif d'électrode de détection plus long et verticalement en-dessous de celui-ci, le dispositif d'électrode de détection plus long étant guidé vers le bas par ses sections extérieures.

4. Dispositif de détection selon une des revendications précédentes, dans lequel le dispositif de commande et d'exploitation est conçu de manière à ce que, lors du contrôle de la détection d'actionnement du dispositif de commande et d'exploitation (5), il soit vérifié si l'ordre des moments de réaction du dispositif d'électrode de détection est égal à l'ordre inversé de défection des électrodes de détection respectives (5).

5. Procédé de détection au niveau d'un véhicule automobile pour l'enregistrement de gestes de mouvement au moyen d'un dispositif de détection capacitif (2, 3) et au moins un dispositif de commande et d'exploitation (5) couplé au dispositif de détection et qui détecte une modification de la capacité du dispositif de détection par rapport à un potentiel de référence,
dans lequel deux dispositifs d'électrodes de détection (2, 3) sont disposés à des positions spatialement décalées au niveau du véhicule automobile, les électrodes de détection (2, 3) étant réalisées sous forme de dispositifs de détection oblongs et avec la même orientation spatiale, un (2) des dispositifs d'électrodes de détection étant réalisé avec une dimension longitudinale supérieure à celle de l'autre (3) dispositif d'électrode de détection, le dispositif d'électrodes de détection le plus long (2) s'étendant dans le sens longitudinal des deux côtés au-delà du dispositif d'électrode de détection (2) plus court,
les électrodes présentant dans la zone horizontale de chevauchement une distance verticale, donc étant superposées,
le dispositif d'électrode de détection le plus long (2) étant déformé au niveau des sections dépassant horizontalement du dispositif d'électrode de détection plus court (3) en direction de la position verticale du dispositif d'électrode de détection plus court (3), comportant les étapes suivantes :
détection d'une suite chronologique de valeurs de capacité de chacun des dispositifs d'électrodes de détection (2, 3) ;
définition des moments de réaction de chaque dispositif d'électrode de détection et de défection de chaque dispositif de détection ;
calcul de la différence de temps de réaction entre les moments de réaction des dispositifs d'électrodes de détection ;
calcul de la différence de temps de défection entre les moments de défection des dispositifs d'électrodes de détection ;
comparaison de la différence de temps de réaction et de la différence de temps de défection ;
détermination de la présence d'un actionnement non valable lorsque la comparaison a pour résultat un écart supérieur à une tolérance prédéterminée entre la différence de temps de réaction et la différence de temps de défection.

6. Procédé selon la revendication 5, dans lequel on vérifie également si l'ordre des moments de réaction des dispositifs d'électrodes de détection est égal à l'ordre inverse de défection des électrodes de détection respectives.

7. Dispositif de détection selon la revendication 5 ou 6, dans lequel la tolérance s'élève à 50 % de la différence chronologique la plus faible, de préférence 20 % de la différence chronologique la plus faible.
